# EUROPÄISCHE PATENTSCHRIFT

(11) **EP 3 472 935 B1**
(45) Veröffentlichungstag und Bekanntmachung des Hinweises auf die Patenterteilung: **19.06.2024**
(21) Anmeldenummer: 17731878.9
(22) Anmeldetag: 21.06.2017
(51) Int. Cl.: H03K 17/96, H03K 17/955

(54) **KAPAZITIVE SENSORVORRICHTUNG MIT VERBESSERTER STÖRTOLERANZ**
CAPACITIVE SENSOR DEVICE WITH IMPROVED INTERFERENCE TOLERANCE
DISPOSITIF DE DÉTECTION CAPACITIVE À TOLÉRANCE D'INTERFERENCE AMÉLIORÉE

(30) Priorität: 15.08.2016 DE 102016115109
(43) Veröffentlichungstag der Anmeldung: 24.04.2019
(73) Patentinhaber: Huf Hülsbeck & Fürst GmbH & Co. KG, 42551 Velbert (DE)
(72) Erfinder: BEXTERMÖLLER, Hubert, 45468 Mülheim a.d.R. (DE)
(74) Vertreter: Zenz Patentanwälte Partnerschaft mbB
(86) Internationale Anmeldenummer: PCT/EP2017/065196
(87) Internationale Veröffentlichungsnummer: WO 2018/033277

(56) Entgegenhaltungen:
- EP-A1- 1 510 637
- EP-A2- 2 053 744
- DE-A1-102014 107 559

## Beschreibung

Die vorliegende Anmeldung betrifft eine Sensorvorrichtung zur kapazitiven Erfassung von Annäherung und/oder Berührung durch einen Benutzer oder ein sonstiges Objekt.

Kapazitive Sensorvorrichtungen sind im Bereich der Technik, insbesondere im Bereich der Fahrzeugtechnik bekannt. Beispielsweise offenbart die DE 10 2014 107 559 A1 eine Sensorvorrichtung für ein Kraftfahrzeug. Kapazitive Sensoren weisen eine oder mehrere Elektroden auf, die sensibel für Kapazitätsänderungen sind. Die Auswertung solcher kapazitiven Sensoren kann auf unterschiedliche Weise erfolgen, beispielsweise sind Auswerteschaltungen im Stand der Technik bekannt und am Markt verfügbar, welche durch Umladevorgänge die Kapazität einer Sensorelektrode gegenüber einer Referenz messen und auswerten.

Außerdem sind im Stand der Technik Anordnungen bekannt, um die Sensitivität und die räumliche Ausrichtung der Erfassung von kapazitiven Sensoren zu verbessern. Dazu werden beispielsweise sogenannte Active-Shield-Elektroden eingesetzt, welche die elektrischen Felder zur Sensierung von Körpern in bestimmte Raumbereiche konzentrieren.

Beispielsweise zeigt die bereits genannte
DE 10 2014 107 559 A1 eine Anordnung mit einem mehrlagigen Elektrodenaufbau. Eine Steuereinrichtung ist jeweils mit Elektroden gekoppelt, die ihrerseits voneinander galvanisch getrennt sind. Die Elektroden können in der Sensorvorrichtung, je nach Ansteuerung durch die Steuer- und Auswerteschaltung, unterschiedliche Funktionen einnehmen. Auch die erfindungsgemäße Sensorvorrichtung weist mehrere Elektroden auf, die galvanisch getrennt und beabstandet voneinander in mehreren Lagen übereinander angeordnet sind. Die Elektroden überlappen dabei wenigstens teilweise, wobei die Überlappung auf eine Richtung senkrecht zu der Erstreckung der Elektrodenlagen gegeben ist. Wie im Stand der Technik sind auch bei der Erfindung die Elektroden mit wenigstens einer Steuer- und Auswerteschaltung gekoppelt, welche die Elektroden in zeitversetzten, aufeinanderfolgenden Zeiträumen derart zur Ausübung wechselnder Funktionen ansteuert, so dass die Elektroden eine kapazitive Sensoranordnung mit zeitlich veränderlicher Elektrodenbelegung bilden.

Die Steuer- und Auswerteschaltung steuert also die Elektrode so an, dass in aufeinanderfolgenden, nicht überlappenden Zeiträumen wenigstens eine der Elektroden aus der Gesamtheit der Elektroden wechselnde Funktionen annimmt. Beispielsweise kann dabei die Funktion der Sensorelektrode von einer Elektrode in einer ersten Lage auf einer Elektrode in einer zweiten Lage übergehen. Regelmäßig wechseln jedoch insbesondere die Funktionen der Schirmelektroden und der Referenzelektroden oder es werden Elektroden zeitweise potentialfrei (floating) geschaltet und so weitgehend funktionslos gesetzt. Dieser zeitliche Wechsel der Elektrodenfunktionen führt zu zeitlich unterschiedlichem Sensorverhalten und zu zeitlich unterschiedlichen Detektionsmöglichkeiten.

Es ist an dieser Stelle zu beachten, dass in einer Lage von Elektroden auch mehrere Elektrodenabschnitte mit galvanischer Trennung angeordnet sein können, so wie dies auch in dem genannten Dokument DE 10 2014 107 559 A1 gezeigt ist. Auf diese Weise können multifunktionale Sensoreinrichtungen mit zeitlich unterschiedlichem Detektionsverhalten und zeitlich unterschiedlicher Sensitivität gebildet werden.

Im Stand der Technik werden derartige Sensoreinrichtungen beispielsweise genutzt, um eine multifunktionale Sensoreinrichtung, beispielsweise in Gestalt einer Mehrlagenplatine, in einem Fahrzeuggriff unterzubringen. Je nach Ansteuerung der Elektroden kann dann die Sensierung einer Annäherung oder Berührung beispielsweise zur Innenseite des Türgriffes hin erfolgen oder zur Außenseite des Türgriffes, je nachdem welche Elektrodenlage in der Mehrlagenplatine als Sensorelektrode betrieben wird.

Das Dokument EP 2 053 744 A2 beschreibt einen kapazitiven Messsensor für den Einsatz im Griff einer Fahrzeugtür, welcher kapazitive Messfelder erzeugt, wobei durch Feldänderung elektrische Signale hervorgerufen werden, um die charakteristische Annäherung von zu bewegenden Objekten an den Messsensor zu bestimmen.

Aus der EP 1 510 637 A1 ist ein Näherungs- oder Berührungssensor für ein Schließsystem eines Straßenfahrzeugs bekannt. Der Sensor ist in einem Türgriff montiert und mit einer Auswerteschaltung verbunden und hat einen äußeren leitenden Sensor und einen inneren leitenden Sensor. Die Sensorstücke können mit einem aktiven haptischen Signalgeber in Kontakt mit einem leitenden Draht gequetscht werden.

Ein Problem der bekannten Sensoreinrichtungen ist in der Störempfindlichkeit von Berührungssensoren und Annäherungssensoren zu sehen. Eine Sensoreinrichtung ist hinsichtlich ihrer Detektionsempfindlichkeit und ihrer Elektrodengeometrie auf einen bestimmten Anwendungsfall ausgelegt. Durch entsprechende Active-Shield-Elektroden kann beispielsweise ein Detektionsraum in einer Raumrichtung erweitert werden, zu Lasten der Detektionsempfindlichkeit in anderen Raumbereichen. Jede Sensoranordnung bringt damit eine eigene Störanfälligkeit und ein eigenes Sensitivitätsprofil mit.

Aufgabe der Erfindung ist es, eine kapazitive Sensoreinrichtung hinsichtlich ihrer Störempfindlichkeit zu verbessern.

Diese Aufgabe wird durch eine Sensorvorrichtung mit den Merkmalen des Patentanspruches 1 sowie ein Verfahren mit den Merkmalen des Anspruchs 10 gelöst.

Erfindungsgemäß ist die wenigstens eine Steuer- und Auswerteschaltung derart ausgelegt, dass sie in zeitlich aufeinanderfolgenden Zeitabschnitten die Elektroden mit veränderlicher Elektrodenbelegung ansteuert. Die Steuer- und Auswerteschaltung kann also verschiedene Konfigurationsschemata aktivieren und entsprechend dieser Konfigurationen übernehmen die Elektroden der Sensorvorrichtung eine zugeordnete Funktion.

Die zugeordneten Funktionen sind ausgewählt aus den Wirkungen als Sensorelektrode, als Active-Shield-Elektrode, als Referenzelektrode oder als zeitweise passive, potentialfreie Elektrode.

Gemäß der Erfindung wird für eine einzige Erfassung eines Sensorsignals jedoch nicht eine einzige Elektrodenkonfiguration ausgewertet. Stattdessen wird die Sensorschaltung mit verschiedenen Konfigurationen aktiviert, jeweils ein Einzelsignal erfasst und die Auswertung bezüglich einer Betätigung erfolgt in Abhängigkeit von sämtlichen Einzelerfassungen. Diese Erfassung der Einzelsignale erfolgt

erfindungsgemäß unmittelbar hintereinander innerhalb von 200 ms. Jede Einzelsignalerfassung kann z.B. einige Millisekunden (z.B. weniger als 20 ms) beanspruchen, so dass eine Erfassung der mehreren Einzelsignale innerhalb von 200 ms erfolgt.

Die Auswertung bezüglich einer Betätigung erfolgt derart, dass eine Konsistenzprüfung der Einzelsignale, die kurz hintereinander erfasst wurden, vorgenommen wird. Nur wenn die Auswertung sämtlicher Einzelsignale zeigt, dass diese sämtlich innerhalb von zueinander konsistenten Grenzen liegen, wird eine Betätigung bestätigt. Diese konsistenten Grenzen könne beim Einlernen eines Systems empirisch ermittelt werden. Es werden z.B. zulässige Bedienvorgänge ausgeführt und dabei wird werden die Signale der verschiedenen Elektrodenkonfigurationen erfasst. Ein gültiger Wertebereich einer Elektrodenkonfiguration kann dann einem gültigen Wertebereich einer anderen Elektrodenkonfiguration zugeordnet werden. Bei der Konsistenzprüfung kann auf die Einhaltung der einander zugeordneten Wertebereiche geprüft werden.

Wie oben beschrieben, weist jede Elektrodenkonfiguration eine eigene, spezifische Störanfälligkeit auf. Durch die Schaltung der Sensorvorrichtung in unterschiedlichen Elektrodenkonfigurationen, wobei dieselben Elektroden zumindest teilweise ihre Funktionen wechseln, und die Zusammenfassung und Kombination dieser Einzelsignale zu einem gesamten Sensorsignal, werden die Störeinflüsse der Einzeleinrichtungen reduziert. Dieser Effekt geht über die Mittelung mehrerer Erfassungen hinaus, da die Elektrodenfunktionen zwischen den Einzelerfassungen geändert werden. Da jedes der aktivierten Profile eine andere Störanfälligkeit und Fehlertoleranz aufweist, kann die Gesamtstöranfälligkeit reduziert werden.

Beispielsweise kann eine Elektrodenkonfiguration mit drei, lagenweise angeordneten Elektroden zur Erfassung eines ersten Signals mit Schaltung einer dem Detektionsraum zugewandten Elektrode als Sensorelektrode und einer weiteren, unterliegenden Elektrode als Referenzelektrode erfolgen. Unmittelbar danach kann eine dazwischenliegende Elektrode zusätzlich als Schirmelektrode aktiviert werden und wiederum ein Signal erfasst werden. Diese Einzelsignale werden zur Auswertung herangezogen. In Abhängigkeit von der Auswertung wird ein Sensorsignal durch die Steuer- und Auswerteschaltung generiert und an eine übergeordnete Stelle, beispielsweise über eine Signalleitung an eine Steuereinrichtung weitergeleitet.

In einer Weiterbildung der Erfindung ist vorgesehen, die separaten Einzelsignale zu einem Gesamtsignal zu kombinieren. Dieses Gesamtsignal wird als Sensorsignal ausgewertet, um die Auswirkungen von Störeinflüssen auf die Sensorvorrichtung zu reduzieren.

Unter Kombination der Signale ist in diesem Zusammenhang jede beliebige rechnerische Kombination, ggf. unter Hinzufügung einer Filterung, zu verstehen. Beispielsweise kann eine additive Überlagerung stattfinden, es können auch Mittelwertbildungen erfolgen oder gewichtete Überlagerungen der Einzelsignale zur Kombination in das Gesamtsignal vorgenommen werden.

In einer Ausführungsform der Erfindung sind wenigstens drei Elektroden vorgesehen, von denen wenigstens zwei zeitversetzt und abwechselnd als Sensorelektrode angesteuert werden, und wobei wenigstens eine Elektrode als Referenzelektrode angesteuert ist.

In dieser Ausführungsform können beispielsweise mehrere, galvanisch getrennte Elektrodenabschnitte in einer Elektrodenlage angeordnet werden, wobei eine Referenzelektrode unterhalb dieser beiden Elektrodenabschnitte liegt. Während eines ersten Messzeitraumes wird ein erster Elektrodenabschnitt der obenliegenden Elektrodenlage als Sensorelektrode aktiviert und die unterliegende Elektrode wird als Referenzelektrode betrieben. Nach Erfassung eines ersten Kapazitätswertes wird der erste, obenliegende Elektrodenabschnitt deaktiviert, der zweite obenliegende Elektrodenabschnitt aktiviert und die Referenzelektrode behält ihre Funktion. Nach Erfassung des zugehörigen Signals werden diese beiden Signale zu einem Gesamtsignal kombiniert und ausgewertet.

Die Störanfälligkeit aufgrund der unterschiedlichen räumlichen Lagen der beiden Sensorelektrodenabschnitte kann in diesem Falle durch die getrennte Erfassung und nachfolgende Kombination verringert werden.

In einer Weiterbildung der Erfindung werden auch die Funktionen der Referenzelektrode zeitversetzt unterschiedlichen Elektrodenabschnitten zugeordnet.

In einer bevorzugten Ausgestaltung der Erfindung ist wenigstens eine der Elektroden und diese wenigstens zweitweise als aktive Schirmelektrode (active shield) angesteuert.

Es ist aus dem Stand der Technik bekannt, dass die aktiven Schirmelektroden eine gerichtete Detektion verbessern können, allerdings bei Verschlechterung der Sensitivität in anderen Raumbereichen als dem bevorzugten Detektionsbereich. Durch den zeitweisen Betrieb einer Elektrode als aktive Schirmelektrode und dem zeitweisen Verzicht oder die Lageänderung dieser Schirmelektrode können die Vorteile einer solchen aktiven Schirmung genutzt werden und die damit verbundene Nachteile reduziert werden.

In einer bevorzugten Ausführung der erfindungsgemäßen Sensorvorrichtung ist für den energieoptimierten Betrieb die Steuer- und Auswerteschaltung derart gebildet, dass die Sensoranordnung zunächst eine Erfassung eines Sensorsignals mit nur einer Elektrodenkonfiguration durchführt. Beispielsweise können in Zeitabständen (z.B. von 50 ms) Sensorsignale in der klassischen Weise als Vorerfassung mit einer ersten Elektrodenkonfiguration erfasst werden. Diese Elektrodenkonfiguration kann auch in diesen Zeitabständen wechseln, so dass also in den Zeitabständen Vorerfassungen mit wechselnder Elektrodenkonfiguration erfasst werden. Erst dann, wenn die Erfassung der Sensorsignale auf diese herkömmliche Weise eine signifikante Veränderung des Sensorsignals zeigt, wird die erfindungsgemäße kombinierte Signalerfassung als Haupterfassung aktiviert. Dann werden im Rahmen der Haupterfassung mehrere Elektrodenkonfigurationen angesteuert und es werden jeweils separate Signalerfassungen unmittelbar hintereinander innerhalb von 200 ms durchgeführt. Diese Signale der Haupterfassung werden ausgewertet oder auch zu einem Gesamtsignal kombiniert und dann ausgewertet. In Abhängigkeit von sämtlichen Einzelsignalen der Haupterfassung erfolgt die Erkennung der Betätigung.

Auf diese Weise ist ein energieoptimierter Betrieb möglich, da die Erfassungshäufigkeit und Umsteuerung der Elektroden reduziert wird.

Es ist bei der vorgenannten Ausführungsform bevorzugt, dass die beschriebenen Vorerfassungen in Zeitabständen, jedoch mit wechselnder Elektrodenbelegung, erfolgen. Auf diese Weise ist die Vorerfassung weniger anfällig für die spezifischen Störanfälligkeiten jeder einzelnen Elektrodenkonfiguration.

Bei der Erfindung ist die Steuer- und Auswerteschaltung so ausgebildet, dass im Zuge der Kombination der mehreren Signalerfassungen zu den verschiedenen Elektrodenkonfigurationen eine Plausibilitätsprüfung anhand eines Vergleichs der separaten Signalerfassungen durchgeführt wird, wobei ausgewertet wird, ob diese sämtlich innerhalb von zueinander konsistenten Grenzen liegen. In Abhängigkeit von der Plausibilitätsprüfung kann dann eine weitere Ansteuerung und Auswertung der Elektroden vorgenommen werden.

Auch wenn die Elektrodenkonfigurationen der jeweiligen Erfassungsschemata unterschiedliche Einzelsignale liefern, werden anhand der Messungen und der empirischen Daten konsistente Einzelsignalkombinationen gebildet werden können. Dies bedeutet, dass beim Betrieb einer Elektrodenanordnung in einer ersten Konfiguration und bei Erfassung einer Annäherung ein Signal erfasst wird, welches einer Konsistenzprüfung mit anderen Elektrodenkonfigurationen bei dem gleichen Ereignis zugeordnet werden kann. Zeigt also beispielsweise das erste Einzelsignal eine Annäherung an die kapazitive Sensoranordnung, das zweite Einzelsignal jedoch keine Annäherung oder Berührung, so kann die Steuer- und Auswerteschaltung eine Wiederholung der Messungen oder eine Verwerfung der Sensordaten vornehmen. Gegenüber einer bloßen redundanten Wiederholung hat dies den Vorteil, dass Störungen und Probleme, die in einer bestimmten Elektrodenkonfiguration begründet werden, nur bei dieser Elektrodenkonfiguration auftreten und bei Konsistenzprüfung mit den anderen Elektrodenkonfigurationen auffallen. Eine solche Plausibilitätsprüfung oder auch Konsistenzprüfung kann vor der Kombination zu einem Gesamtsignal oder im Zuge der Kombination zu einem Gesamtsignal erfolgen.

In einer weiteren Ausgestaltung der Erfindung sind mehrere Steuer- und Auswerteschaltungen vorgesehen, die jeweils mit denselben Elektroden gekoppelt sind. Dies kann beispielsweise zur Erhöhung der Sicherheit oder auch der besonderen Konfigurationen der einzelnen Steuer- und Auswerteschaltungen erfolgen. Es kann so vorgesehen sein, dass eine Elektrodenanordnung zunächst mit einer ersten Steuer- und Auswerteschaltung gekoppelt wird, um ein erstes Signal zu erfassen. Dann wird diese erste Steuer- und Auswerteschaltung abgekoppelt und eine zweite Steuer- und Auswerteschaltung wird mit denselben Elektroden gekoppelt, um ein zweites Signal zu erfassen. Die Signale, einerseits erfasst durch die erste Steuer- und Auswerteschaltung und andererseits erfasst durch die zweite Steuer- und Auswerteschaltung, werden anschließend ausgewertet oder auch zu einem Gesamtsignal kombiniert.

Die Erfindung wird nun anhand der beiliegenden Zeichnungen näher erläutert.
Figur 1 zeigt schematisch die Anordnung einer erfindungsgemäßen Sensorvorrichtung;
Figur 2 zeigt ein Ansteuerschema für die Anordnung aus Figur 1;
Figuren 3a, 3b und 3c zeigen schematisch den Feldlinienverlauf von drei Elektroden bei unterschiedlicher Funktionsbelegung;
Figuren 4a, 4b, 4c und 4d zeigen schematisch frequenzabhängige Störanfälligkeiten von unterschiedlichen Elektrodenkonfigurationen sowie eine kombinierte Störanfälligkeit bei einer Gesamtsignalauswertung.

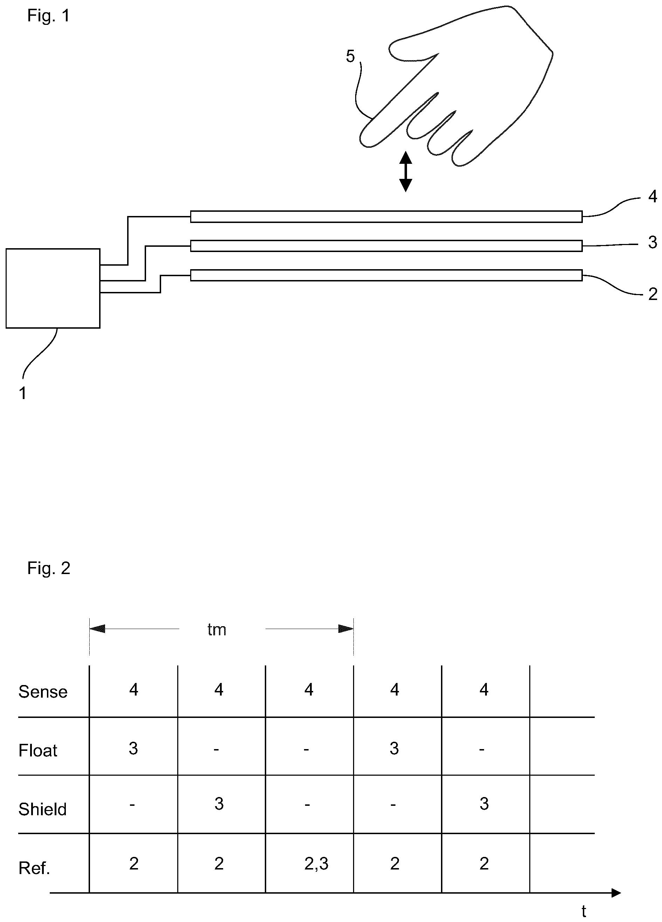

In Figur 1 ist eine Steuer- und Auswerteschaltung 1 gezeigt, welche mit drei Elektroden 2, 3, 4 gekoppelt ist. Eine Hand 5 eines Benutzers nähert sich der Elektrodenanordnung. Die Elektroden 2, 3, 4 sind beispielsweise in einem Fahrzeugtürgriff oder in der Nähe eines Fahrzeugtürgriffes angeordnet. Ebenso kann die Steuer- und Auswerteschaltung 1 in einem Fahrzeugtürgriff oder in dessen Nähe angeordnet sein.

Die Steuer- und Auswerteschaltung ist ausgebildet, um die Elektroden 2, 3, 4 zeitversetzt mit unterschiedlichen Elektrodenfunktionen zu belegen.

In einer zeitlichen Abfolge belegt die Steuer- und Auswerteschaltung 1 die Elektroden 2, 3, 4 gemäß dem Schema, welches in Figur 2 gezeigt ist. Entlang der Zeitachse t sind jeweils die Bezugszeichen der Elektroden den jeweiligen Funktionen zugeordnet. Dabei ist die Funktion der Sensorelektrode mit dem Wort "sense" gekennzeichnet. Eine potentialfreie gestaltete Elektrode ist mit der Funktion "Float" bezeichnet. Eine aktive Schirmung wird durch eine Elektrode mit der Funktion "Shield" übernommen. Die Bezugselektrode, beispielsweise auf dem Massepotenzial gehalten, ist mit der Bezeichnung "Ref." versehen.

Es ist gemäß dem Schema aus Figur 2 ersichtlich, dass in einem Erfassungszeitraum tm, welcher verschiedene Elektrodenkonfigurationen übergreift, zunächst die obere Elektrode 4 als Sensorelektrode betrieben wird, die Elektrode 3 wird dabei potentialfrei geschaltet und die Elektrode 2 dient als Referenzelektrode. In dieser Konfiguration erfolgt eine erste Signalerfassung. Nachfolgend wird die Elektrode 3 als aktive Schirmelektrode betrieben, dabei wird sie beispielsweise auf dasselbe Potential gelegt wie die Sensorelektrode 4, wobei jedoch die Elektrode 3 nicht hinsichtlich ihrer Kapazität ausgewertet wird.

In einem dritten Schritt werden sowohl die Elektrode 2 als auch die Elektrode 3 als Referenzelektrode betrieben und die Elektrode 4 bleibt die Sensorelektrode. Die Einzelmessungen dieser verschiedenen Kombinationen werden zu einem Gesamtsignal kombiniert und einer Auswertung zugeführt.

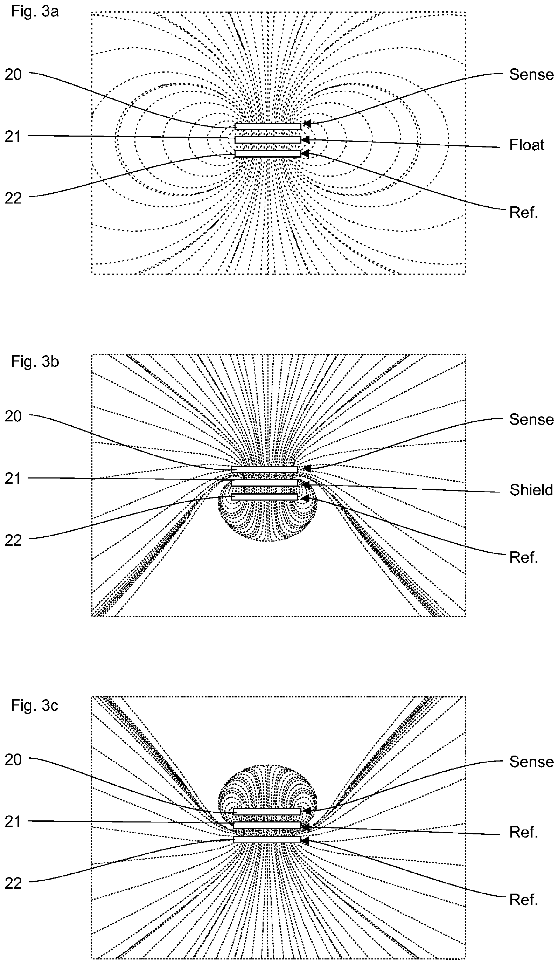

Die Figuren 3a, 3b und 3c zeigen mit denselben Bezeichnungen (Sense, Float, Shield, Ref.) schematisch die Auswirkungen der verschiedenen Elektrodenkonfigurationen auf den Verlauf der Feldlinien. Es ist in Figur 3a erkennbar, dass die Schaltung gemäß am ersten Elektrodenschema mit einer obenliegenden Sensorelektrode und einer untenliegenden Referenzelektrode sowie einer zwischenliegenden potentialfreien Elektrode eine andere Feldlinienverteilung bietet, als wenn die Mittelelektrode als Schirmelektrode geschaltet wird, wie in Figur 3b gezeigt. Die Verwendung einer Schirmelektrode konzentriert die Feldlinien in ausgewählte Bereiche. Die dargestellten Feldlinienverläufe sind dabei nur modellhaft zu verstehen, sie verdeutlichen jedoch die verschiedenen Elektrodenkonfigurationen und die daraus resultierenden unterschiedlichen Sensitivitäten und Störanfälligkeiten.

Die in Figur 3c gezeigte Elektrodenanordnung, ohne Schirmelektrode, jedoch mit der Schaltung der Referenzelektrode auch als Mittelelektrode, verringert den Bereich der Sensitivität vor der Sensorelektrode erheblich. Diese Elektrodenkonfiguration ist entsprechend besonders sensitiv für eine Annäherung oder Berührung unmittelbar an der Sensorelektrode.

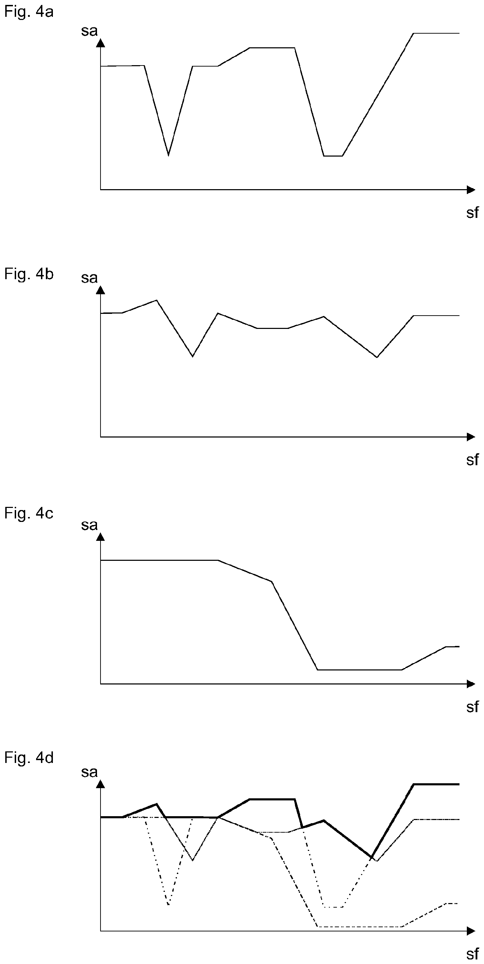

Die Figuren 4a, 4b und 4c zeigen, ebenfalls schematisch und beispielhaft, die Anfälligkeit für Störungen bei unterschiedlichen Elektrodenkonfigurationen. Die Figuren 4a, 4b und 4c zeigen also jeweils gegenüber einer Störfrequenz eine tolerierte Störamplitude in Abhängigkeit von der Frequenz. Jede der Elektrodenkonfigurationen hat gemäß dieser Darstellung eine eigene charakteristische Störanfälligkeit über den Frequenzbereich. Die erfindungsgemäße Kombination der Einzelmessungen zu einer Gesamtmessung, um zu einem Sensorsignal zu gelangen, ist in Figur 4d dargestellt. Dort sind die Einzelverläufe der Figuren 4a, 4b und 4c gezeigt und eine Art einhüllende Kurve, welche die tolerierte Störamplitude der kombinierten Messungen darstellt. Es wird anhand dieser Figuren verdeutlicht, dass die Fehlauslösung (Bedienungserkennung trotz nicht vorliegender Bedienung) aufgrund von Störeinflüssen Abhängig von der Elektrodenkonfiguration ist. Wird jedoch eine wechselnde Elektrodenkonfiguration geschaltet und werden sämtliche Einzelmessungen berücksichtigt, um eine Bedienung zu erkennen, wird die Wahrscheinlichkeit einer Fehlerkennung einer Bedienung reduziert.

Gemäß der Erfindung ist es möglich, eine kapazitive Sensoreinrichtung mit reduzierter Störanfälligkeit auszubilden. Dabei werden Sensorelektroden in unterschiedlichen Konfigurationen als kapazitive Sensoranordnungen betrieben und zu den jeweiligen Konfigurationen Einzelmessungen durchgeführt, wobei jedoch nicht die Einzelmessungen, sondern ein kombiniertes Gesamtsignal aus den Einzelmessungen ausgewertet wird.

## Patentansprüche

1. Sensorvorrichtung zur kapazitiven Erfassung von Annäherungen und/oder Berührungen durch einen Benutzer (5),
wobei die Sensorvorrichtung mehrere Elektroden (2, 3, 4) aufweist, welche galvanisch getrennt und beabstandet voneinander und in mehreren Lagen übereinander angeordnet sind, wobei die Elektroden (2, 3, 4) in einer Richtung senkrecht zu den Lagen wenigstens teilweise überlappen,
wobei die Elektroden (2, 3, 4) mit wenigstens einer Steuer- und Auswerteschaltung (1) gekoppelt sind, welche die Elektroden in aufeinander folgenden Zeiträumen derart zur Ausübung wechselnder Funktionen ansteuern, so dass die Elektroden eine kapazitive Sensoranordnung mit zeitlich veränderlicher Elektrodenbelegung bilden,
**dadurch gekennzeichnet,**
**dass** die Steuer- und Auswerteschaltung (1) derart ausgebildet ist, dass sie zur Erfassung jeder Betätigung die Elektroden (2, 3, 4) unmittelbar hintereinander innerhalb von 200ms mit wenigstens zwei verschiedenen Elektrodenbelegungen ansteuert, wobei für jede Elektrodenbelegung wenigstens eine separate Signalerfassung erfolgt und wobei die Steuer- und Auswerteschaltung auswertet, ob diese sämtlich innerhalb von zueinander konsistenten Grenzen liegen und eine Betätigung in Abhängigkeit von sämtlichen separaten Signalerfassungen erfasst.

2. Sensorvorrichtung nach Anspruch 1, wobei Steuer- und Auswerteschaltung (1) derart ausgebildet ist, dass sie die mehreren separaten Signalerfassungen zu einem Gesamtsignal kombiniert und in Abhängigkeit von dem Gesamtsignal eine Betätigung ermittelt.

3. Sensorvorrichtung nach Anspruch 1 oder 2, wobei wenigstens drei Elektroden vorgesehen sind, von denen wenigstens zwei zeitversetzt und abwechselnd als Sensorelektrode angesteuert werden und wobei wenigstens eine Elektrode als Referenzelektrode angesteuert ist.

4. Sensorvorrichtung nach Anspruch 3, wobei wenigstens zwei der Elektroden zeitversetzt und abwechselnd als Referenzelektrode angesteuert werden.

5. Sensorvorrichtung nach einem der vorangehenden Ansprüche, wobei wenigstens eine der Elektroden wenigstens zeitweise als aktive Schirmelektrode (active shield) angesteuert ist.

6. Sensorvorrichtung nach einem der vorangehenden Ansprüche, wobei die wenigstens eine Steuer- und Auswerteschaltung ausgebildet ist, um zur Einsparung von Energie die Elektroden in vorgegebenen ersten Zeitabständen für eine Vorerfassung mit einer einzigen Elektrodenbelegung anzusteuern und auszuwerten und in Abhängigkeit von der Vorerfassung die Elektroden zur Haupterfassung nacheinander mit wenigstens zwei verschiedenen Elektrodenbelegungen ansteuert und die daraus resultierenden mehreren separaten Signalerfassungen auswertet und eine Betätigung in Abhängigkeit von sämtlichen separaten Signalerfassungen der Haupterfassung erfasst.

7. Sensorvorrichtung nach Anspruch 6, wobei die Vorerfassung in den vorgegebenen ersten Zeitabständen mit wechselnder Elektrodenbelegung erfolgt.

8. Sensorvorrichtung nach einem der vorangehenden Ansprüche, wobei die Steuer- und Auswertevorrichtung bei der Kombination der mehreren Signalerfassungen zu einem Gesamtsignal eine Plausibilitätsprüfung anhand eines Vergleichs der separaten Signalerfassungen durchführt und in Abhängigkeit von der Plausibilitätsprüfung eine weitere Ansteuerung und Auswertung der Elektroden vornimmt.

9. Sensorvorrichtung nach einem der vorangehenden Ansprüche, wobei wenigstens zwei Steuer- und Auswertevorrichtungen vorgesehen sind, welche mit denselben Elektroden koppelbar sind, so dass die kapazitive Sensoranordnung zeitversetzt von unterschiedlichen Steuer- und Auswertevorrichtungen ansteuerbar ist.

10. Verfahren zum Erfassen einer Betätigung mit einer kapazitiven Sensorvorrichtung,
bei welcher mehrere Elektroden galvanisch getrennt und beabstandet voneinander und in mehreren Lagen übereinander angeordnet sind, wobei die Elektroden in einer Richtung senkrecht zu den Lagen wenigstens teilweise überlappen,
wobei die Elektroden in aufeinander folgenden Zeiträumen derart zur Ausübung wechselnder Funktionen angesteuert werden, so dass die Elektroden eine kapazitive Sensoranordnung mit zeitlich veränderlicher Elektrodenbelegung bilden,
**dadurch gekennzeichnet,**
**dass** zur Erfassung jeder Betätigung, die Elektroden unmittelbar hintereinander innerhalb von 200ms mit wenigstens zwei verschiedenen Elektrodenbelegungen angesteuert werden, wobei für jede Elektrodenbelegung wenigstens eine separate Signalerfassung durchgeführt wird, und
wobei die mehreren separaten Signalerfassungen ausgewertet werden, ob diese sämtlich innerhalb von zueinander konsistenten Grenzen liegen und eine Betätigung in Abhängigkeit von sämtlichen separaten Signalerfassungen erfasst wird.

11. Verfahren nach Anspruch 10, wobei die mehreren separaten Signalerfassungen zu einem Gesamtsignal kombiniert werden und in Abhängigkeit von dem Gesamtsignal eine Betätigung ermittelt wird.

12. Verfahren nach Anspruch 10 oder 11, wobei wenigstens zwei Elektroden zeitversetzt und abwechselnd als Sensorelektrode angesteuert werden und wobei wenigstens eine Elektrode als Referenzelektrode angesteuert wird.

13. Verfahren nach Anspruch 12, wobei wenigstens zwei der Elektroden zeitversetzt und abwechselnd als Referenzelektrode angesteuert werden.

14. Verfahren nach einem der Ansprüche 11 bis 13, wobei wenigstens eine der Elektroden wenigstens zeitweise als aktive Schirmelektrode (active shield) angesteuert ist.

15. Verfahren nach einem der Ansprüche 10 bis 14, wobei zur Einsparung von Energie die Elektroden in vorgegebenen ersten Zeitabständen für eine Vorerfassung mit einer einzigen Elektrodenbelegung angesteuert und ausgewertet werden und in Abhängigkeit von der Vorerfassung die Elektroden zur Haupterfassung nacheinander mit wenigstens zwei verschiedenen Elektrodenbelegungen angesteuert werden, und wobei die daraus resultierenden mehreren separaten Signalerfassungen der Haupterfassung ausgewertet werden und eine Betätigung in Abhängigkeit von sämtlichen separaten Signalerfassungen der Haupterfassung erfasst wird.

## Claims

1. Sensor device for the capacitive detection of approaches and/or touches by a user (5),
wherein the sensor device comprises several electrodes (2, 3, 4) which are galvanically disconnected and spaced apart from each other and arranged in several layers one above the other, wherein the electrodes (2, 3, 4) at least partially overlap in a direction perpendicular to the layers,
wherein the electrodes (2, 3, 4) are coupled to at least one control and evaluation circuit (1) which controls the electrodes in successive time periods in such a way as to perform alternating functions, so that the electrodes form a capacitive sensor arrangement with time-varying electrode configuration,
**characterized in that**,
the control and evaluation circuit (1) is designed such that, in order to detect each actuation, it controls the electrodes (2, 3, 4) immediately one after the other within 200ms with at least two different electrode configurations, at least one separate signal detection taking place for each electrode configuration, and the control and evaluation circuit evaluating whether these are all within mutually consistent limits and detecting an actuation as a function of all separate signal detections.

2. Sensor device according to claim 1, wherein the control and evaluation circuit (1) is designed in such a way that it combines the several separate signal detections into an overall signal and determines an actuation as a function of the overall signal.

3. Sensor device according to claim 1 or 2, wherein at least three electrodes are provided, of which at least two are actuated with a time delay and alternately as sensor electrode and wherein at least one electrode is actuated as reference electrode.

4. Sensor device according to claim 3, wherein at least two of the electrodes are controlled with a time delay and alternately as a reference electrode.

5. Sensor device according to one of the preceding claims, wherein at least one of the electrodes is controlled at least temporarily as an active shield electrode.

6. Sensor device according to one of the preceding claims, wherein the at least one control and evaluation circuit is designed to control and evaluate the electrodes at predetermined first time intervals for a pre-detection with a single electrode configuration in order to save energy and, as a function of the pre-detection, controls the electrodes for the main detection successively with at least two different electrode configurations and evaluates the resulting plurality of separate signal detections and detects an actuation as a function of all separate signal detections of the main detection.

7. Sensor device according to claim 6, wherein the pre-detection takes place at the predetermined first time intervals with alternating electrode configuration.

8. Sensor device according to one of the preceding claims, wherein the control and evaluation device carries out a plausibility check based on a comparison of the separate signal acquisitions when combining the several signal acquisitions to form an overall signal and carries out a further activation and evaluation of the electrodes as a function of the plausibility check.

9. Sensor device according to one of the preceding claims, wherein at least two control and evaluation devices are provided which can be coupled to the same electrodes, so that the capacitive sensor arrangement can be actuated with a time delay by different control and evaluation devices.

10. Method for detecting an actuation with a capacitive sensor device,
in which a plurality of electrodes is arranged galvanically disconnected and spaced apart from one another and in a plurality of layers one above the other, the electrodes at least partially overlapping in a direction perpendicular to the layers,
wherein the electrodes are actuated in successive time periods in such a way as to perform alternating functions, so that the electrodes form a capacitive sensor arrangement with a time-varying electrode configuration,
**characterized in that**,
to detect each actuation, the electrodes are actuated immediately one after the other within 200ms with at least two different electrode configurations, at least one separate signal detection being carried out for each electrode configuration, and
wherein the plurality of separate signal acquisitions are analysed to determine whether they all lie within mutually consistent limits and an actuation is detected as a function of all the separate signal acquisitions.

11. Method according to claim 10, wherein the plurality of separate signal acquisitions are combined to form an overall signal and an actuation is determined as a function of the overall signal.

12. Method according to claim 10 or 11, wherein at least two electrodes are actuated with a time delay and alternately as sensor electrode and wherein at least one electrode is actuated as reference electrode.

13. Method according to claim 12, wherein at least two of the electrodes are controlled with a time delay and alternately as reference electrode.

14. Method according to one of claims 11 to 13, wherein at least one of the electrodes is controlled at least temporarily as an active shield electrode.

15. Method according to one of claims 10 to 14, wherein, in order to save energy, the electrodes are actuated and evaluated at predetermined first time intervals for a pre-detection with a single electrode configuration and, depending on the pre-detection, the electrodes for the main detection are actuated successively with at least two different electrode configurations, and wherein the resulting plurality of separate signal detections of the main detection are evaluated and an actuation is detected depending on all the separate signal detections of the main detection.

## Revendications

1. Dispositif de détection pour la détection capacitive d'approches et/ou d'effleurements par un utilisateur (5),
le dispositif de détection présentant plusieurs électrodes (2, 3, 4) qui sont séparées galvaniquement et espacées les unes des autres et disposées les unes sur les autres en plusieurs couches, les électrodes (2, 3, 4) se chevauchant au moins partiellement dans une direction perpendiculaire aux couches,
les électrodes (2, 3, 4) étant couplées à au moins un circuit de commande et d'évaluation (1) qui commande les électrodes dans des périodes successives de manière à exercer des fonctions alternées, de sorte que les électrodes forment un agencement de capteurs capacitifs avec une occupation des électrodes variable dans le temps,
**caractérisé en ce que**
le circuit de commande et d'évaluation (1) est conçu de telle sorte que, pour la détection de chaque actionnement, il commande les électrodes (2, 3, 4) directement l'une derrière l'autre en l'espace de 200 ms avec au moins deux occupations d'électrodes différentes, au moins une détection de signal séparée étant effectuée pour chaque occupation d'électrode et le circuit de commande et d'évaluation évaluant si celles-ci se situent toutes à l'intérieur de limites mutuellement cohérentes et détectant un actionnement en fonction de toutes les détections de signaux séparées.

2. Dispositif de détection selon la revendication 1, le circuit de commande et d'évaluation (1) étant conçu de telle sorte qu'il combine les plusieurs détections de signaux séparées en un signal global et détermine un actionnement en fonction du signal global.

3. Dispositif de détection selon la revendication 1 ou 2, dans lequel il est prévu au moins trois électrodes, dont au moins deux sont commandées de manière décalée dans le temps et en alternance en tant qu'électrode de détection et dans lequel au moins une électrode est commandée en tant qu'électrode de référence.

4. Dispositif de détection selon la revendication 3, dans lequel au moins deux des électrodes sont commandées de manière décalée dans le temps et en alternance en tant qu'électrode de référence.

5. Dispositif de détection selon l'une quelconque des revendications précédentes, dans lequel au moins l'une des électrodes est commandée au moins temporairement en tant qu'électrode à écran actif (active shield).

6. Dispositif de détection selon l'une quelconque des revendications précédentes, dans lequel l'au moins un circuit de commande et d'évaluation est conçu pour, afin d'économiser de l'énergie, commander et évaluer les électrodes à des premiers intervalles de temps prédéterminés pour une pré-détection avec une seule occupation d'électrode et, en fonction de la pré-détection, commander les électrodes pour la détection principale successivement avec au moins deux occupations d'électrodes différentes et évaluer les plusieurs détections de signaux séparées qui en résultent et détecter un actionnement en fonction de toutes les détections de signaux séparées de la détection principale.

7. Dispositif de détection selon la revendication 6, dans lequel la pré-détection s'effectue dans les premiers intervalles de temps prédéfinis avec une occupation alternée des électrodes.

8. Dispositif de détection selon l'une quelconque des revendications précédentes, le dispositif de commande et d'évaluation effectuant, lors de la combinaison des plusieurs captures de signaux en un signal global, un contrôle de plausibilité à l'aide d'une comparaison des captures de signaux séparées et effectuant, en fonction du contrôle de plausibilité, une autre commande et évaluation des électrodes.

9. Dispositif de détection selon l'une quelconque des revendications précédentes, dans lequel il est prévu au moins deux dispositifs de commande et d'évaluation qui peuvent être couplés aux mêmes électrodes, de sorte que le dispositif de détection capacitif peut être commandé de manière décalée dans le temps par différents dispositifs de commande et d'évaluation.

10. Procédé de détection d'un actionnement avec un dispositif de détection capacitif,
dans lequel plusieurs électrodes sont séparées galvaniquement et espacées les unes des autres et sont superposées en plusieurs couches, les électrodes se chevauchant au moins partiellement dans une direction perpendiculaire aux couches,
les électrodes étant commandées dans des périodes successives de manière à exercer des fonctions alternées, de sorte que les électrodes forment un agencement de capteurs capacitifs dont l'occupation des électrodes varie dans le temps,
**caractérisé en ce que**
pour la détection de chaque actionnement, les électrodes sont commandées directement l'une après l'autre en l'espace de 200 ms avec au moins deux occupations d'électrodes différentes, au moins une détection de signaux séparée étant effectuée pour chaque occupation d'électrodes, et
les multiples détections de signaux séparées étant évaluées pour savoir si elles se situent toutes à l'intérieur de limites cohérentes les unes par rapport aux autres et un actionnement étant détecté en fonction de toutes les détections de signaux séparées.

11. Procédé selon la revendication 10, dans lequel les plusieurs détections de signaux séparées sont combinées en un signal global et un actionnement est déterminé en fonction du signal global.

12. Procédé selon la revendication 10 ou 11, dans lequel au moins deux électrodes sont commandées de manière décalée dans le temps et en alternance en tant qu'électrode de détection et dans lequel au moins une électrode est commandée en tant qu'électrode de référence.

13. Procédé selon la revendication 12, dans lequel au moins deux des électrodes sont commandées de manière décalée dans le temps et en alternance en tant qu'électrode de référence.

14. Procédé selon l'une quelconque des revendications 11 à 13, dans lequel au moins l'une des électrodes est commandée au moins temporairement en tant qu'électrode à écran actif (active shield).

15. Procédé selon l'une quelconque des revendications 10 à 14, dans lequel, pour économiser de l'énergie, les électrodes sont commandées et évaluées à des premiers intervalles de temps prédéterminés pour une pré-détection avec une seule occupation d'électrode et, en fonction de la pré-détection, les électrodes sont commandées successivement pour la détection principale avec au moins deux occupations d'électrodes différentes, et dans lequel les plusieurs détections de signaux séparées de la détection principale qui en résultent sont évaluées et un actionnement est détecté en fonction de toutes les détections de signaux séparées de la détection principale.
